# EUROPEAN PATENT APPLICATION

(11) **EP 4 425 197 A1**
(43) Date of publication of application: **04.09.2024**
(21) Application number: 23159147.0
(22) Date of filing: 28.02.2023
(51) Int. Cl.: G01R 31/34

(54) **METHOD OF MONITORING THERMAL PARAMETERS OF AN ELECTRICAL MACHINE**

(71) Applicant: ABB SCHWEIZ AG, 5400 Baden (CH)
(72) Inventor: KAKOSIMOS, Panagiotis, Västerås (SE); RÖNNBERG, Kristian, Västerås (SE); NORDLUND, Erik, Västerås (SE); KOLONDJOVSKI, Zlatko, Vantaa (FI)
(74) Representative: Kransell & Wennborg KB

(57) **Abstract**

A method of monitoring thermal parameters of a thermal model of an electrical machine, the method comprising: a) updating thermal parameter values of the thermal model based on temperature measurements of the electrical machine, b) estimating future values of the thermal parameters based on the updated thermal parameter values by means of a degradation model, which takes past behaviour of the thermal parameters into account, and c) determining a future degradation and/or a remaining useful life of the electrical machine based on the future values.

## Description

### TECHNICAL FIELD

The present disclosure generally relates to electrical machines.

### BACKGROUND

Thermal models are used to predict the temperature distribution in electrical machines. Several thermal modelling approaches are currently in use for estimating the temperature distribution. These include finite element and computational fluid dynamics thermal models and lumped-parameter thermal network (LPTN) models. LPTN models are preferable due to the inherent simplicity and fast calculation times.

In an LPTN, the distribution of the heat flow and temperature in the electrical machine is estimated by using an equivalent circuit which comprises thermal resistances, thermal capacitances, and heat sources. The geometry and material properties are used to derive the thermal parameters in the design phase.

As a measure to adapt the thermal model to the changing characteristics of an electrical machine over time, WO 2021254986 discloses a method of monitoring an electrical machine, comprising minimizing a difference between temperature measurement values and estimated temperatures by finding optimal weight parameter values of a thermal model of the electrical machine, and repeating these steps over and over during operation of the electrical machine.

### SUMMARY

A general object of the present disclosure is to provide a method of monitoring thermal parameters of an electrical machine, which solves or at least mitigates problems of the prior art.

There is hence according to a first aspect of the present disclosure provided a method of monitoring thermal parameters of a thermal model of an electrical machine, the method comprising: a) updating thermal parameter values of the thermal model based on temperature measurements of the electrical machine, b) estimating future values of the thermal parameters based on the updated thermal parameter values by means of a degradation model, which takes past behaviour of the thermal parameters into account, and c) determining a future degradation and/or a remaining useful life of the electrical machine based on the future values.

Based on this monitoring, an action or actions may be taken to change the trajectory of the future values of the thermal parameters. The degradation process of the electrical machine may thereby be slowed down and the remaining useful life may be increased.

The future values may for example be respective trajectories for the thermal parameters of the thermal model.

The future values may be extrapolated based on the updated thermal parameter values and the past behaviour.

The degradation model may for example be a regression model, a neural network model, a reliability model, or a Bayesian model.

The thermal model may be for example be a lumped parameter thermal network, a finite element method model or a finite volume method model.

The thermal parameters may for example be thermal resistances, thermal capacitances, and heat sources.

The thermal model may for example be updated as described in WO2021254986 by optimization of weight parameters of the thermal model after comparing estimated temperatures with measured temperatures, or by a machine learning process.

Steps a)-c) may be repeated over and over during the operation of the electrical machine.

Steps b) and c) may be performed less often than step a).

The updated thermal parameter values obtained in step a) may be stored. Thus, sets of updated thermal parameter values obtained at a plurality of different instances in time may be stored as a result of step a) being repeated over and over.

Steps b) and c) may be performed online or offline.

The electrical machine may be a motor or a generator.

According to one embodiment the degradation model takes current electrical machine conditions into account when estimating the future values of the thermal parameters.

According to one embodiment the current electrical machine conditions include at least one of ambient temperature, load, speed, and internal temperatures of the electrical machine.

The future values may be extrapolated based on trends determined based on the updated thermal parameter values, the historical values of the thermal parameters, obtained from stored updated thermal parameter values, and further based on the current electrical machine conditions.

According to one embodiment the degradation model takes past behaviour of the thermal parameters of a fleet of electrical machines of the same type into account. Thus, the past behaviour of corresponding thermal parameters of a fleet of electrical machines of the same type as the presently monitored electrical machine may be used to determine the future values for example using statistical methods such as Bayesian theory. The probability distribution of a future value may be obtained by estimating the likelihood of observing an updated thermal parameter value given the prior probability distribution of values of this thermal parameter of the fleet and multiplying it with the prior probability distribution of values of the same thermal parameter. If the operating conditions of the electrical machine change, the likelihood of observing an updated thermal parameter value may be modified to reflect the new operating conditions. If for example, the relationship between an updated thermal parameter value and the prior probability distribution is highly nonlinear, such as due to different operating conditions, neural networks may be used to estimate the likelihood of observing the updated thermal parameter value. In case a single future value is required for a thermal parameter, from the probability distribution of the future value, for example if used in the thermal model in step c) the single future value may be selected from the probability distribution of the future value. If for example, the probability distribution of the future value is a normal distribution, the mean value may be selected for this purpose.

According to one embodiment the future degradation is an occurrence of one or more future hotspots determined by re-evaluating the thermal model with the future values.

According to one embodiment the future degradation is a future defect in the electrical machine determined based on a magnitude greater than a threshold value of at least one of the future values.

According to one embodiment the future defect is a degradation of insulation of the electrical machine. Degradation of the insulation is typically the result of operating at higher than normal temperatures, which can be caused by for example dirt build-up, blocked fans, etc.

According to one embodiment the remaining useful life is determined based on the future values and on past values of at least one of the thermal parameters.

According to one example if a future value exceeds a predetermined threshold, the remaining useful life may be determined based on the magnitude with which the future value exceeds the predetermined threshold. One example may involve determining an indicator based on past values of all the thermal parameters and current electrical machine conditions, wherein the indicator is used to determine the remaining useful life of the electrical machine. A similar approach as described above may be used for example if Bayesian theory is used, except that in this case the values of all the thermal parameters may be entered as input to the degradation model, and the output from the degradation model may be an indicator.

According to one example, the remaining useful life is determined further based on run-to-failure behaviour of the thermal parameters from a fleet of electrical machines of the same type as the present electrical machine.

One embodiment comprises, after step c), performing a mitigating action based on the future degradation and/or a remaining useful life, in an attempt to reduce the degradation and/or increase the remaining useful life.

According to one embodiment the mitigating action comprises generating an alarm, presenting a recommendation to an operator, and/or controlling the electrical machine.

According to one embodiment the recommendation is to clean off dirt from the electrical machine, and the controlling involves reducing the load of the electrical machine.

The controlling may alternatively, or additionally, include changing a fan speed, if the electric machine is cooled by an external fan, increase the speed of the electrical machine if a fan blade is attached to the shaft, or cooling the room in which the electrical machine is located.

One embodiment comprises, after performing the mitigating action, performing steps a) to c).

There is according to a second aspect of the present disclosure provided a computer program comprising computer code which when executed by processing circuity of a control system causes the control system to perform the method of the first aspect.

There is according to a third aspect of the present disclosure provided a control system comprising: a storage medium comprising computer code, and processing circuitry configured to execute the computer code, causing the control system to execute the steps of the method of the first aspect.

There is according to a fourth aspect of the present disclosure provided an electrical machine system comprising: a control system of the third aspect, and an electrical machine.

Generally, all terms used in the claims are to be interpreted according to their ordinary meaning in the technical field, unless explicitly defined otherwise herein. All references to "a/an/the element, apparatus, component, means, etc. are to be interpreted openly as referring to at least one instance of the element, apparatus, component, means, etc., unless explicitly stated otherwise.

### BRIEF DESCRIPTION OF THE DRAWINGS

The specific embodiments of the inventive concept will now be described, by way of example, with reference to the accompanying drawings, in which:
Fig. 1 schematically shows an example of a control system for monitoring thermal parameters of a thermal model of an electrical machine, and for controlling the electrical machine;
Fig. 2 is a flowchart of a method of monitoring thermal parameters of a thermal model of an electrical machine by means of the control system in Fig. 1; and
Fig. 3 is an electrical machine system comprising the control system in Fig. 1 and an electrical machine.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

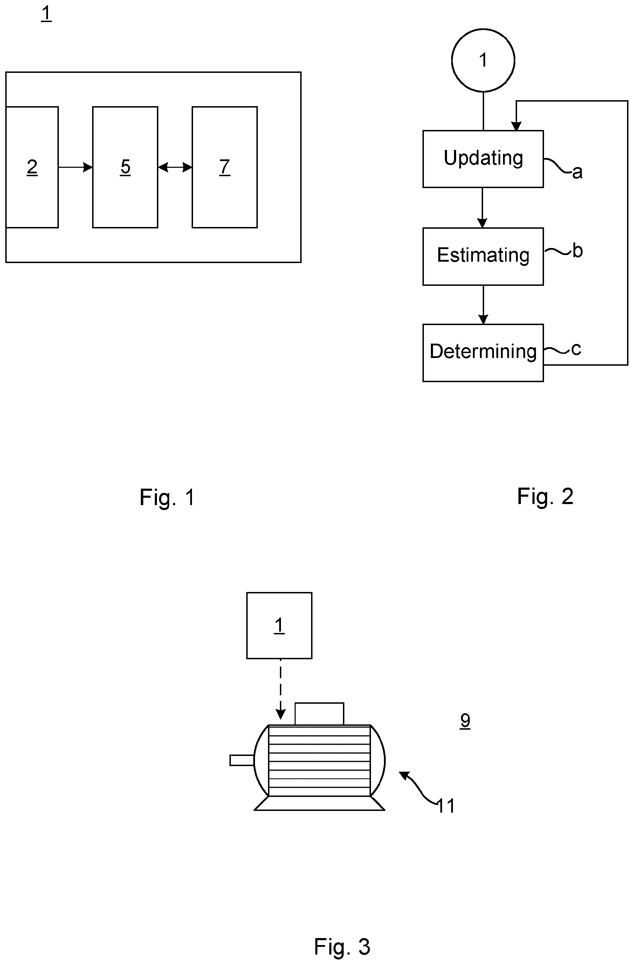

Fig. 1 depicts a block diagram of an example of a control system 1. The control system 1 is configured to control and monitor the condition and/or the performance of an electrical machine. The electrical machine may be a motor or a generator.

The electrical machine comprises a plurality of temperature sensors each configured to measure the temperature in a respective one of a plurality of different locations of the electrical machine. The temperature sensors may for example be configured to detect the temperature of the stator windings, the rotor windings, the rotor surface and/or the stator chassis.

The control system 1 comprises an input unit 2 configured to receive temperature measurement values from the temperature sensors. The control system 1 may be configured to receive the temperature measurement values by wireless, wired, or a combination of wireless and wired communication.

The control system 1 comprises processing circuitry 5 configured to receive the temperature measurement values from the input unit 2. The control system 1 may comprise a storage medium 7.

The storage medium 7 may comprise a computer program including computer code which when executed by the processing circuitry 7 causes the control system 1 to perform the method as disclosed herein.

The processing circuitry 5 may for example use any combination of one or more of a suitable central processing unit (CPU), multiprocessor, microcontroller, digital signal processor (DSP), application specific integrated circuit (ASIC), field programmable gate arrays (FPGA) etc., capable of executing any herein disclosed operations concerning the monitoring of an electrical machine.

The storage medium 7 may for example be embodied as a memory, such as a random access memory (RAM), a read-only memory (ROM), an erasable programmable read-only memory (EPROM), or an electrically erasable programmable read-only memory (EEPROM) and more particularly as a non-volatile storage medium of a device in an external memory such as a USB (Universal Serial Bus) memory or a Flash memory, such as a compact Flash memory.

A method of monitoring thermal parameters of a thermal model of an electrical machine will now be described with reference to Fig. 2.

The control system 1 stores a thermal model of the electrical machine that it is to control. The thermal model may for example be stored in the storage medium 7.

The thermal model describes the thermal behaviour of the electrical machine by means of thermal parameters such as thermal resistances, thermal capacitances, and heat losses. The thermal model may comprise a plurality of thermal resistances, thermal capacitances, and heat losses, and each thermal resistance, thermal capacitance, and heat loss may correspond to a respective thermal parameter.

In a step a) thermal parameter values of the thermal model are updated based on temperature measurements of the electrical machine. The updating in step a) may involve changing the values of the thermal parameters as such or values of associated weight parameters, where required.

For example, step a) may involve comparing estimated temperatures obtained from the thermal model with corresponding temperature measurements, and the thermal parameter values may for example be updated by changing weight parameters in the thermal model, associated with the respective thermal parameter, which minimise the difference between the estimated temperatures and measured temperatures.

In a step b) future values of the thermal parameters are estimated by means of a degradation model.

The future values are estimated based on the updated thermal parameter values by means of the degradation model. The input to the degradation model may be an updated thermal parameter value or the probability distribution of values of the thermal parameter. The degradation model takes past behaviour of the thermal parameters into account. The past behaviour may include stored thermal parameter values, which are updated thermal parameter values, from previous executions of step a) or the past behaviour may include stored distributions of the values of updated thermal parameter values from previous executions of step a).

Each future value may be a single value or a probability distribution of the future value. In case a single future value is required for a thermal parameter, from the probability distribution of a future value, the single future value may be selected from the probability distribution of the future value.

The degradation model may further take current electrical machine conditions into account when estimating the future values of the thermal parameters. The current electrical machine conditions include at least one of ambient temperature, load, speed, and internal temperatures of the electrical machine.

In a step c) a future degradation and/or a remaining useful life of the electrical machine is determined based on the future values.

The future degradation may for example be an occurrence of one or more future hotspots determined by re-evaluating the thermal model with the future values, and/or a future defect in the electrical machine determined based on a magnitude greater than a threshold value of at least one of the future values.

A future defect may for example be the degradation of insulation of the electrical machine.

The remaining useful life may be determined based on the future values and on past values of at least one of the thermal parameters.

One example comprises, after step c), a step of performing a mitigating action in an attempt to reduce the degradation and/or increase the remaining useful life. The mitigating action may comprise generating an alarm such as a visual or audible alarm, to allow for an operator to take manual actions, and/or presenting a recommendation to an operator, and/or controlling the electrical machine.

The recommendation may for example be to clean off dirt from the electrical machine. Controlling may involve reducing the load of the electrical machine, speed control of the electrical machine, controlling a fan that cools the electrical machine, and/or increasing cooling in the space in which the electrical machine is installed.

After performing the mitigating action, steps a) to c) may be performed to determine whether the future degradation and/or a remaining useful life of the electrical machine is improved after the mitigation action has been performed.

As an illustrative example, dirt may accumulate on the electrical machine, slowly reducing the thermal conductivity and thus the cooling capability of the electrical machine in a region where the dirt is accumulated. This changes the temperature behaviour of the electrical machine and thus in step a) the thermal parameter values are updated so that the thermal model correctly estimates the temperatures in the electrical machine. The thermal parameters that are changed may be thermal resistances, which increase as the dirt increases and the thermal conductivity decreases. As the dirt accumulates the thermal parameter values are successively updated over time to always adapt the thermal model to the changing thermal behaviour of the electrical machine. All or most iterations of the thermal parameter values thus updated may be stored in the storage medium 7. In step b) the future values of the thermal parameters are estimated by means of the degradation model, using the updated thermal parameter values, the stored thermal parameter values of their past behaviour, and current conditions of the electrical machine. The future values may for example be provided in the form of respective trajectories for each thermal parameter, as single values, or as probability distributions. In step c) the future degradation and/or a remaining useful life of the electrical machine is determined based on the future values. For example, future hotspots may be determined by using the future values with the thermal model and/or future defects in the electrical machine may be determined based on a magnitude greater than a threshold value of at least one of the future values. The method may then generate an alarm, a recommendation, or control of the electrical machine and/or of cooling equipment for cooling the electrical machine. If the mitigating action was a recommendation to remove dirt from the electrical machine, and the operator removes the dirt, in a subsequent iteration of step a) the thermal resistance(s) affected by the removed dirt decreases and the thermal model is updated accordingly. The updated thermal parameter values are thus used to perform step b), resulting in improved results concerning future degradation and/or a remaining useful life.

Fig. 3 shows an electrical machine system 9 comprising an exemplary electrical machine 11 and the control system 1 configured to control the electrical machine 11.

The inventive concept has mainly been described above with reference to a few examples. However, as is readily appreciated by a person skilled in the art, other embodiments than the ones disclosed above are equally possible within the scope of the inventive concept, as defined by the appended claims.

## Claims

1. A method of monitoring thermal parameters of a thermal model of an electrical machine (11), the method comprising:
a) updating thermal parameter values of the thermal model based on temperature measurements of the electrical machine (11),
b) estimating future values of the thermal parameters based on the updated thermal parameter values by means of a degradation model, which takes past behaviour of the thermal parameters into account, and
c) determining a future degradation and/or a remaining useful life of the electrical machine (11) based on the future values.

2. The method as claimed in claim 1, wherein the degradation model takes current electrical machine conditions into account when estimating the future values of the thermal parameters.

3. The method as claimed in claim 2, wherein the current electrical machine conditions include at least one of ambient temperature, load speed, and internal temperatures of the electrical machine.

4. The method as claimed in any of the preceding claims, wherein the degradation model takes past behaviour of the thermal parameters of a fleet of electrical machines of the same type into account.

5. The method as claimed in any of the preceding claims, wherein the future degradation is an occurrence of one or more future hotspots determined by re-evaluating the thermal model with the future values.

6. The method as claimed in any of the preceding claims, wherein the future degradation is a future defect in the electrical machine (11) determined based on a magnitude greater than a threshold value of at least one of the future values.

7. The method as claimed in claim 6, wherein the future defect is a degradation of insulation of the electrical machine (11).

8. The method as claimed in any of the preceding claims, wherein the remaining useful life is determined based on the future values and on past values of at least one of the thermal parameters.

9. The method as claimed in any of the preceding claims, comprising, after step c), performing a mitigating action based on the future degradation and/or a remaining useful life, in an attempt to reduce the degradation and/or increase the remaining useful life.

10. The method as claimed in claim 9, wherein the mitigating action comprises generating an alarm, presenting a recommendation to an operator, and/or controlling the electrical machine.

11. The method as claimed in claim 10, wherein the recommendation is to clean off dirt from the electrical machine (11), and the controlling involves reducing the load of the electrical machine (11).

12. The method as claimed in any of claims 9-11, comprising, after performing the mitigating action, performing steps a) to c).

13. A computer program comprising computer code which when executed by processing circuity (5) of a control system (1) causes the control system (1) to perform the method as claimed in any of claims 1-12.

14. A control system (1) comprising:
a storage medium (7) comprising computer code, and
processing circuitry (5) configured to execute the computer code, causing the control system (1) to execute the steps of the method as claimed in any of claims 1-12.

15. An electrical machine system (9) comprising:
a control system (1) as claimed in claim 14, and
an electrical machine (11).
